# EUROPEAN PATENT APPLICATION

(11) **EP 4 687 261 A1**
(43) Date of publication of application: **04.02.2026**
(21) Application number: 25189600.7
(22) Date of filing: 15.07.2025
(51) Int. Cl.: H02J 7/00, H02J 7/34

(54) **EXTERNAL BATTERY DEVICE AND CHARGING CONTROL METHOD OF THE SAME**

(30) Priority: 30.07.2024 KR 20240100984
(71) Applicant: SAMSUNG SDI CO., LTD., Yongin-si, Gyeonggi-do 17084 (KR)
(72) Inventor: OH, Seo Taek, Suwon-si, Gyeonggi-do 16678 (KR)
(74) Representative: Gulde & Partner

(57) **Abstract**

An external battery device includes a battery, an input terminal that receives external power from a charger connected through a universal serial bus, USB, cable, a charging unit that charges the battery, and a processor configured to measure a voltage value of a first data terminal of the input terminal, set a charging current based on the voltage value of the first data terminal, and control the charging unit to charge the battery with the charging current that is set.

## Description

### BACKGROUND

### 1. Field

Embodiments of the present disclosure relate to an external battery device and a charging control method therefor.

### 2. Description of the Related Art

Recently, electronic devices such as notebooks, mobile phones, personal digital assistants (PDAs), and the like are being used in a portable state by users. These portable electronic devices mainly receive electrical energy required for use through batteries. Functions of the portable electronic device are being diversified so that other functions are gradually added in addition to their own functions, and thus various functions can be performed with only a single portable electronic device. Accordingly, the electrical energy required for use is gradually increasing, and thus, higher-capacity basic batteries are desirable.

To this end, an external battery is used which is not attached to a portable electronic device to be used and can be carried by a user.

The external battery is typically charged using a dedicated adapter, and if the dedicated adapter is not used, a case where the adapter is damaged due to excessive charging current of the external battery, or the battery is not charged occurs.

The above-described information disclosed in the background technology of the present disclosure is only for improving understanding of the background of the present disclosure, and accordingly, can include information that does not constitute the related art.

The above information disclosed in this background section is for enhancement of understanding of the background of the present disclosure, and therefore, it may contain information that does not constitute related (or prior) art.

### SUMMARY

Embodiments include an external battery device, including a battery, an input terminal that receives external power from a charger connected through a universal serial bus (USB) cable, a charging unit that charges the battery, and a processor configured to measure a voltage value of a first data terminal of the input terminal, set a charging current based on the voltage value of the first data terminal, and control the charging unit to charge the battery with the charging current that was set.

The processor may be further configured to compare the voltage value of the first data terminal with a preset reference range to set the charging current.

The processor may be further configured to set a first charging current for a first reference range as the charging current if the voltage value of the first data terminal is in the first reference range, may set a second charging current set for a second reference range as the charging current if the voltage value of the first data terminal is in the second reference range, and may set a third charging current set for a third reference range as the charging current if the voltage value of the first data terminal is in the third reference range.

The processor may be further configured to measure a voltage drop of the first data terminal for a preset time during charging with the charging current that is set, and may maintain or change the charging current that is set based on the voltage drop of the first data terminal.

The processor may be further configured to measure the voltage value of the first data terminal if a preset time has elapsed after charging of the battery starts, and compare the voltage value of the first data terminal measured with an initial voltage value of the first data terminal to measure the voltage drop of the first data terminal.

The processor may be further configured to maintain the charging current that is set if the voltage drop of the first data terminal is lower than or equal to a preset threshold.

The processor may be further configured to reset the charging current to a charging current lower than the charging current that is set and control the charging unit to charge the battery with the charging current that is reset if the voltage drop of the first data terminal exceeds a preset threshold.

The input terminal may include a power terminal connected to a power pin of the charger, a first data terminal (D-) connected to a first data pin (D-) of the charger, and a second data terminal (D+) connected to a second data pin (D+) of the charger.

The charging unit may convert the external power supplied to the power terminal of the input terminal into the charging current and supply the charging current to the battery.

The external battery device may further include a direct current (DC)-DC converter that converts an output voltage of the battery into a voltage having a different magnitude and transmits the voltage to an output terminal connected to an external device.

Embodiments include an external battery device, including a battery, an input terminal that receives external power from a charger connected through a USB cable, a charging unit that charges the battery, and a processor configured to measure a voltage value of a first data terminal of the input terminal, set a charging current based on the voltage value of the first data terminal, control the charging unit to charge the battery with the charging current that is set, measure a voltage drop of the first data terminal for a preset time during charging with the charging current that is set, and maintain or change the charging current that is set based on the voltage drop of the first data terminal.

The processor may be further configured to compare the voltage value of the first data terminal with a preset reference range to set the charging current.

The processor may be further configured to measure the voltage value of the first data terminal if a preset time has elapsed after charging of the battery starts, and compare the voltage value of the first data terminal measured with an initial voltage value of the first data terminal to measure the voltage drop of the first data terminal.

The processor may be further configured to maintain the charging current that is set if the voltage drop of the first data terminal is lower than or equal to a preset threshold.

The processor may be further configured to reset the charging current to a charging current lower than the charging current that is set and charge the battery with the charging current that is reset if the voltage drop of the first data terminal exceeds a preset threshold.

Embodiments include a charging control method of an external battery device, the charging control method including measuring, by a processor, a voltage value of a first data terminal of an input terminal to which a USB cable is connected if a charger is connected through the USB cable, setting, by the processor, a charging current based on the voltage value of the first data terminal, and controlling, by the processor, a charging unit to charge a battery with the charging current that is set.

In the setting of the charging current, the processor may compare the voltage value of the first data terminal with a preset reference range to set the charging current.

After the controlling, the method may further include measuring, by the processor, a voltage drop of the first data terminal for a preset time after charging of the battery starts, and maintaining or changing the charging current that is set based on the voltage drop of the first data terminal.

In the maintaining or changing of the charging current that is set, the voltage value of the first data terminal if a preset time has elapsed after charging of the battery starts, and may compare the voltage value of the first data terminal measured with an initial voltage value of the first data terminal to measure the voltage drop of the first data terminal.

In the maintaining or changing of the charging current that is set, the charging current set is maintained by the processor if the voltage drop of the first data terminal is lower than or equal to a preset threshold, and may reset the charging current to a charging current lower than the charging current that is set and controls the charging unit to charge the battery with the charging current that is reset if the voltage drop of the first data terminal exceeds the preset threshold.

However, effects that can be achieved through the present disclosure are not limited to the above-described effects and other effects that are not described may be clearly understood by those of ordinary skill in the art from the detailed descriptions.

### BRIEF DESCRIPTION OF DRAWINGS

Features will become apparent to those of ordinary skill in the art by describing in detail exemplary embodiments with reference to the attached drawings, in which:
FIG. 1 is a view for describing charging of an external battery device according to one or more embodiments of the present disclosure;
FIG. 2 schematically illustrates a configuration of the external battery device according to one or more embodiments of the present disclosure;
FIG. 3 illustrates a universal serial bus (USB) terminal of a charger and an input terminal of the external battery device according to one or more embodiments of the present disclosure;
FIG. 4 schematically illustrates a circuit of the input terminal of the external battery device according to one or more embodiments of the present disclosure;
FIG. 5 illustrates an example of an input voltage and a full load (VL) voltage according to one or more embodiments of the present disclosure;
FIG. 6 illustrates a flow chart for describing a charging control method of the external battery device according to one or more embodiments of the present disclosure;
FIG. 7 illustrates a flow chart for describing a charging control method of an external battery device according to one or more embodiments of the present disclosure; and
FIG. 8 illustrates a flow chart for describing a charging control method of an external battery device according to one or more embodiments of the present disclosure.

### DETAILED DESCRIPTION

Example embodiments will now be described more fully hereinafter with reference to the accompanying drawings; however, they may be embodied in different forms and should not be construed as limited to the embodiments set forth herein. Rather, these embodiments are provided so that this disclosure will be thorough and complete, and will fully convey exemplary implementations to those skilled in the art.

In the drawing figures, the dimensions of layers and regions may be exaggerated for clarity of illustration. It will also be understood that if a layer or element is referred to as being "on" another layer or substrate, it can be directly on the other layer or substrate, or intervening layers may also be present. Further, it will be understood that if a layer is referred to as being "under" another layer, it can be directly under, and one or more intervening layers may also be present. In addition, it will also be understood that if a layer is referred to as being "between" two layers, it can be the only layer between the two layers, or one or more intervening layers may also be present. Like reference numerals refer to like elements throughout.

Hereinafter, embodiments of the present disclosure will be described, in detail, with reference to the accompanying drawings. The terms or words used in this specification and claims should not be construed as being limited to the usual or dictionary meaning and should be interpreted as meaning and concept consistent with the technical idea of the present disclosure based on the principle that the inventor can be his/her own lexicographer to appropriately define the concept of the term to explain his/her disclosure in the best way.

The embodiments described in this specification and the configurations shown in the drawings are only some of the embodiments of the present disclosure and do not represent all of the technical ideas, aspects, and features of the present disclosure. Accordingly, it should be understood that there may be various equivalents and modifications that can replace or modify the embodiments described herein at the time of filing this application.

It will be understood that if an element or layer is referred to as being "on," "connected to," or "coupled to" another element or layer, it may be directly on, connected, or coupled to the other element or layer or one or more intervening elements or layers may also be present. If an element or layer is referred to as being "directly on," "directly connected to," or "directly coupled to" another element or layer, there are no intervening elements or layers present. For example, if a first element is described as being "coupled" or "connected" to a second element, the first element may be directly coupled or connected to the second element or the first element may be indirectly coupled or connected to the second element via one or more intervening elements.

In the figures, dimensions of the various elements, layers, etc. may be exaggerated for clarity of illustration. The same reference numerals designate the same elements. As used herein, the term "and/or" includes any and all combinations of one or more of the associated listed items. Further, the use of "may" if describing embodiments of the present disclosure relates to "one or more embodiments of the present disclosure." Expressions, such as "at least one of" and "any one of," if preceding a list of elements, modify the entire list of elements and do not modify the individual elements of the list. If phrases such as "at least one of A, B and C, "at least one of A, B or C," "at least one selected from a group of A, B and C," or "at least one selected from among A, B and C" are used to designate a list of elements A, B and C, the phrase may refer to any and all suitable combinations or a subset of A, B and C, such as A, B, C, A and B, A and C, B and C, or A and B and C. As used herein, the terms "use," "using," and "used" may be considered synonymous with the terms "utilize," "utilizing," and "utilized," respectively. As used herein, the terms "substantially," "about," and similar terms are used as terms of approximation and not as terms of degree, and are intended to account for the inherent variations in measured or calculated values that would be recognized by those of ordinary skill in the art.

It will be understood that, although the terms first, second, third, etc. may be used herein to describe various elements, components, regions, layers, and/or sections, these elements, components, regions, layers, and/or sections should not be limited by these terms. These terms are used to distinguish one element, component, region, layer, or section from another element, component, region, layer, or section. Thus, a first element, component, region, layer, or section discussed below could be termed a second element, component, region, layer, or section without departing from the teachings of example embodiments.

Spatially relative terms, such as "beneath," "below," "lower," "above," "upper," and the like, may be used herein for ease of description to describe one element or feature's relationship to another element(s) or feature(s) as illustrated in the figures. It will be understood that the spatially relative terms are intended to encompass different orientations of the device in use or operation in addition to the orientation depicted in the figures. For example, if the device in the figures is turned over, elements described as "below" or "beneath" other elements or features would then be oriented "above" or "over" the other elements or features. Thus, the term "below" may encompass both an orientation of above and below. The device may be otherwise oriented (rotated 90 degrees or at other orientations), and the spatially relative descriptors used herein should be interpreted accordingly.

The terminology used herein is for the purpose of describing embodiments of the present disclosure and is not intended to be limiting of the present disclosure. As used herein, the singular forms "a" and "an" are intended to include the plural forms as well, unless the context clearly indicates otherwise. It will be further understood that the terms "includes," "including," "comprises," and/or "comprising," if used in this specification, specify the presence of stated features, integers, steps, operations, elements, and/or components but do not preclude the presence or addition of one or more other features, integers, steps, operations, elements, components, and/or groups thereof.

Also, any numerical range disclosed and/or recited herein is intended to include all subranges of the same numerical precision subsumed within the recited range. For example, a range of "1.0 to 10.0" is intended to include all subranges between (and including) the recited minimum value of 1.0 and the recited maximum value of 10.0, that is, having a minimum value equal to or greater than 1.0 and the maximum value equal to or less than 10.0, such as, for example, 2.4 to 7.6. Any maximum numerical limitation recited herein is intended to include all lower numerical limitations subsumed therein, and any minimum numerical limitation recited in this specification is intended to include all higher numerical limitations subsumed therein. Accordingly, the applicant reserves the right to amend this specification, including the claims, to expressly recite any sub-range subsumed within the ranges expressly recited herein. All such ranges are intended to be inherently described in this specification such that amending to expressly recite any such subranges would comply with the requirements of 35 U.S.C. § 112(a) and 35 U.S.C. § 132(a).

References to two compared elements, features, etc. as being "the same" may mean that they are "substantially the same". Thus, the phrase "substantially the same" may include a case having a deviation that is considered low in the art, for example, a deviation of 5% or less. In addition, if a certain parameter is referred to as being uniform in a given region, it may mean that it is uniform in terms of an average.

Throughout the specification, unless otherwise stated, each element may be singular or plural.

If an arbitrary element is referred to as being disposed (or located or positioned) on the "above (or below)" or "on (or under)" a component, it may mean that the arbitrary element is placed in contact with the upper (or lower) surface of the component and may also mean that another component may be interposed between the component and any arbitrary element disposed (or located or positioned) on (or under) the component.

In addition, it will be understood that if an element is referred to as being "coupled," "linked" or "connected" to another element, the elements may be directly "coupled," "linked" or "connected" to each other, or an intervening element may be present therebetween, through which the element may be "coupled," "linked" or "connected" to another element. In addition, if a part is referred to as being "electrically coupled" to another part, the part can be directly connected to another part or an intervening part may be present therebetween such that the part and another part are indirectly connected to each other.

Throughout the specification, if "A and/or B" is stated, it means A, B or A and B, unless otherwise stated. That is, "and/or" includes any or all combinations of a plurality of items enumerated. If "C to D" is stated, it means C or more and D or less, unless otherwise specified.

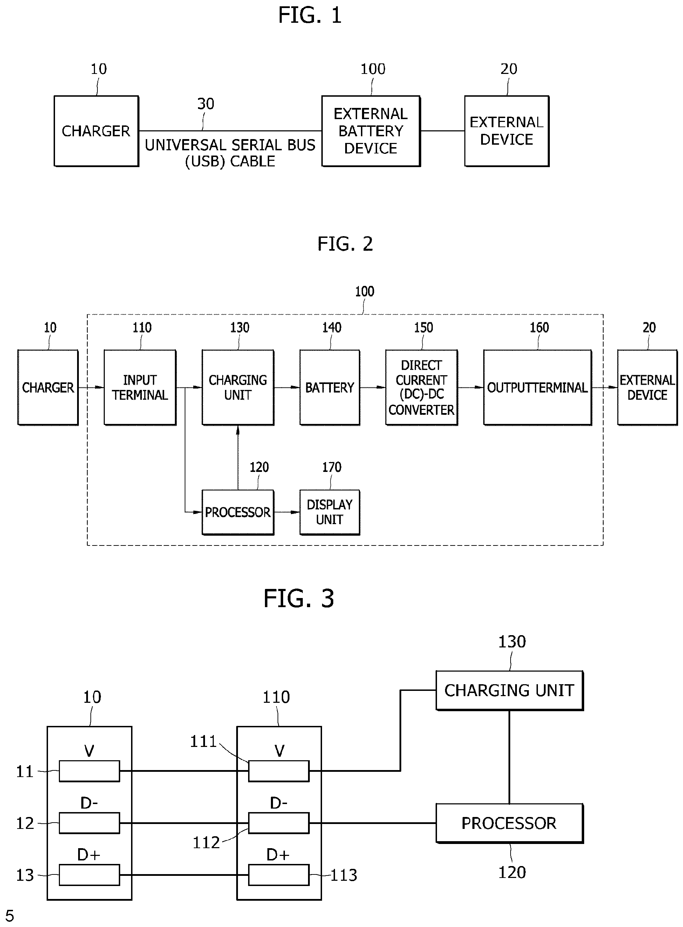

FIG. 1 is a view for describing charging of an external battery device according to one or more embodiments of the present disclosure.

Referring to FIG. 1, an external battery device 100 may charge an external device 20 while receiving external power from a charger (e.g., a travel adaptor) 10 and being charged.

Here, the external device 20 may include all devices driven by a built-in battery, such as a personal digital assistant (PDA), a mobile phone, a smart phone, a notebook, a tablet, and the like, and may include various types of devices which are driven by receiving electrical energy supplied from the external battery device 100 or charge a battery included in the external device 20 using the electrical energy supplied from the external battery device 100.

The external battery device 100 may be a device which is connected to the charger 10 through a charging cable 30 and receives external power from the charger 10 through the charging cable 30 to charge a battery 140 (see FIG. 2) of the external battery device 100 or provide power of the battery 140 to the external device 20. That is, the external battery device 100 may be any device having the battery 140 and which may provide power to the external device 20. Here, the charging cable 30 may be a universal serial bus (USB) cable 30 (e.g., a USB-C cable).

As shown in FIG. 2, the external battery device 100 may include an input terminal 110 and an output terminal 160, receive external power through the input terminal 110, and supply the power to the external device 20 through the output terminal 160. In this case, if the external power is supplied from the input terminal 110, the external battery device 100 may provide a portion of the external power to the external device 20 connected to the output terminal 160 through the output terminal 160, and may charge the battery 140 using the remainder of the external power. That is, the external battery device 100 may simultaneously supply the power to the external device 20 and charge the battery 140.

Meanwhile, the maximum output current of the charger 10 may be set to 0.5A, 1.0A, 2.0A, and the like depending on types (specifications), and the charger 10 may be configured so that quick charging (fast charging) is possible as the maximum output current of the charger 10 is higher.

The external battery device 100 may set the charging current to a current lower than or equal to the maximum output current of the charger 10 to perform charging. That is, since the maximum output current of the charger 10 varies for the specifications of the charger 10, it is necessary to control the charging current supplied to the external battery device 100.

Accordingly, if the charger 10 is connected through the USB cable 30, the external battery device 100 may recognize a specification (type) of the charger 10, set the charging current depending on the recognized specification (type) of the charger 10, and control the battery 140 to be charged. In this case, the external battery device 100 may recognize the charger 10 based on a voltage value of a first data terminal 112 (see FIG. 3) of the input terminal 110 to which the USB cable 30 is connected.

Since the external battery device 100 is configured to recognize the charger 10 using the voltage value of the first data terminal 112 of the input terminal 110, there is a possibility of misrecognizing the charger 10.

If the charger 10 is misrecognized, the external battery device 100 may set the charging current to be higher or lower than the maximum output current of the charger 10. If the charging current of the external battery device 100 is set to be lower than the maximum charging current of the charger 10, there is no problem during charging of the external battery device 100. However, if the charging current of the external battery device 100 is set to be higher than the maximum charging current of the charger 10, a problem may occur not only in the external battery device 100 but also in the charger 10. For example, if the battery 140 of the external battery device 100 is charged with a charging current set to be higher than the maximum charging current of the charger 10, an overload may occur, which may cause damage to the charger 10 and the external battery device 100.

In order to prevent the overload from occurring, the external battery device 100 may measure a voltage drop of the first data terminal 112 for a preset time during charging, and maintain or change the set charging current based on the voltage drop of the first data terminal 112.

The external battery device 100 will be described in more detail with reference to FIG. 2.

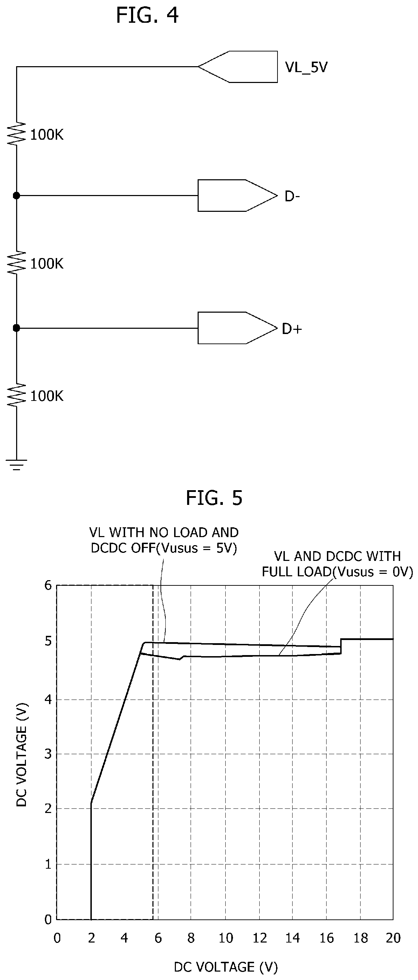

FIG. 2 schematically illustrates a configuration of the external battery device according to one or more embodiments of the present disclosure, FIG. 3 illustrates a USB terminal of the charger and the input terminal of the external battery device according to one or more embodiments of the present disclosure, FIG. 4 schematically illustrates a circuit of the input terminal of the external battery device according to one or more embodiments of the present disclosure, and FIG. 5 illustrates an example of an input voltage and a full load (VL) voltage according to one or more embodiments of the present disclosure.

Referring to FIG. 2, the external battery device 100 according to one or more embodiments of the present disclosure may include the input terminal 110, a charging unit 130, the battery 140, a direct current (DC)-DC converter 150, the output terminal 160, a display unit 170, and a processor 120.

The input terminal 110 may be a portion connected to the terminal of the charger 10 and may transmit the external power supplied from the charger 10 to the charging unit 130. That is, the input terminal 110 may be a portion connected to the terminal of the USB cable 30 connected to the charger 10, and may transmit the external power supplied from the charger 10 to the charging unit 130.

As shown in FIG. 3, the charger 10 may include a USB terminal including a power pin 11, a first data pin 12, and a second data pin 13. As shown in FIG. 3, the input terminal 110 of the external battery device 100 may include a power terminal 111 connected to the power pin 11, a first data terminal 112 connected to the first data pin 12, and a second data terminal 113 connected to the second data pin 13. Here, the first data pin 12 and the first data terminal 112 may be D- or D+, and the second data pin 13 and the second data terminal 113 may be a pin and a terminal other than the first data pin 12 and the first data terminal 112. Hereinafter, for convenience of description, the first data pin 12 will be described as being D- and the second data pin 13 will be described as being D+.

The power terminal 111 may be a terminal which receives power from the power pin 11 of the charger 10 to charge the battery 140. The power terminal 111 may provide the power supplied from the charger 10 to the charging unit 130.

The processor 120 may receive the magnitude of the voltage applied to the first data terminal (D-) 112 of the input terminal 110.

The charging unit 130 may output the charging current set by the processor 120 to the battery 140 to charge the battery 140.

The charging unit 130 may include a charging circuit which may charge the battery 140.

The charging unit 130 may generate the charging current using the external power supplied from the power terminal 111 of the input terminal 110 and supply the charging current to the battery 140 to allow the battery 140 to be charged, or supply the charging current to the external device 20 to allow the external device 20 to be charged.

The magnitude of the charging current output from the charging unit 130 may vary depending on the specifications of the charger 10 connected to the input terminal 110. For example, depending on the specifications of the charger 10, the magnitude of the charging current output from the charging unit 130 may have various values, such as 500 mA, 1 A, 2 A, and the like.

Accordingly, the processor 120 may sense the voltage value flowing to the first data terminal (D-) 112 of the input terminal 110 to distinguish the specifications of the charger 10, and control the charging unit 130 so that the charging current according to the specifications of the charger 10 is output from the charging unit 130.

The battery 140 may have a certain capacity to charge power, and charge the power supplied from the charging unit 130. The battery 140 may be configured as a secondary battery including, for example, a lead-acid battery, a lithium-ion battery, or the like which may be charged and discharged. However, the type of battery 140 to be used is not limited thereto, and all types of various batteries known in the art may be used as the battery 140.

The battery 140 may be a battery cell which may be charged and discharged and in which an electrode assembly having a positive electrode/separator/negative electrode structure is sealed in a battery case while being impregnated with a lithium electrolyte. This electrode assembly generally has a jelly-roll structure (a wound type) in which long sheet-shaped positive and negative electrodes with active materials applied on both surfaces are wound in a round shape with a separator interposed therebetween, and a stacked structure (a stacked type) in which a plurality of positive electrodes and negative electrodes of certain sizes with active materials applied on both surfaces are sequentially stacked with a separator interposed therebetween.

Depending on shapes of the cell, all of cylindrical type and prismatic type bare cells with an electrode assembly built into a cell case of a metal can, and a pouch-type bare cell with an electrode assembly built into a cell case of an aluminum laminate sheet may be used as the battery 140. Further, the battery 140 may have a structure in which two or more battery cells are connected in series and/or parallel.

The DC-DC converter 150 may convert the voltage output from the battery 140 into a voltage having a magnitude for charging the external device 20 and transmit the voltage to the output terminal 160.

If the external device 20 is connected to the external battery device 100, the voltage output from the battery 140 may be boosted through the DC-DC converter 150 and supplied to the external device 20 through the output terminal 160.

The output terminal 160 may be connected to the external device 20 and transmit the electrical energy supplied from the battery 140 to the external device 20. The output terminal 160 may be implemented in various shapes depending on the type of the external device 20.

The display unit 170 may display a capacity, a remaining capacity, a charging progress state, a charged amount, whether a protection circuit is operating, whether fast/wireless charging is being performed, and the like of the battery 140 under control of the processor 120. The processor 120 may control the display unit 170 using the voltage of the battery 140.

The display unit 170 may be implemented as a display, a lamp, or the like.

The processor 120 may be configured to control the charger 10 to charge the external device 20 while receiving the external power from the charger 10 and being charged. That is, if external power is supplied from the input terminal 110, the processor 120 may provide a portion of the external power to the external device 20 connected to the output terminal 160 and charge the battery 140 using the remainder of the external power.

The processor 120 may further be configured to measure the voltage value of the first data terminal (D-) 112 of the input terminal 110, set the charging current based on the voltage value of the first data terminal (D-) 112, and control the charging unit 130 to charge the battery 140 with the set charging current.

Specifically, if the charger 10 is connected through the USB cable 30, the processor 120 may measure the voltage value of the first data terminal (D-) 112 of the input terminal 110 to which the USB cable 30 is connected. That is, the processor 120 may receive the magnitude of the voltage applied to the first data terminal (D-) 112 of the input terminal 110.

The processor 120 may recognize a specification (type) of the charger 10 based on the voltage value of the first data terminal (D-) 112 and set the charging current depending on the recognized specification (type) of the charger 10.

The maximum output current (or a rated charging current) may be set to 0.5A, 0.7A, 1.0A, 2.0A, or the like depending on the type (specification) of the charger 10. Further, the states of the first data terminal (D-) 112 and the second data terminal (D+) 113 of the charger 10 which may be charged are set depending on the type (specification).

For example, in the case of a first charger that performs charging if the first data terminal (D-) 112 and the second data terminal (D+) 113 are in an open state, the maximum output current may be 0.5A, and the voltage value of the first data terminal (D-) 112 may be in a range of 3.0 to 3.6 V.

As shown in FIG. 4, if a first charger having a maximum output current of 500 mA is connected to the external battery device 100 in which the first data terminal (D-) 112 and the second data terminal (D+) 113 of the input terminal 110 are implemented, and a 5 V voltage is input through the power terminal 111, the processor 120 may acquire 5 V*((100 K+100 K)/(100 K+100 K+100 K)) = 3.3 V which is a voltage value of the first data terminal (D-) 112. Since 3.3 V acquired as the voltage value of the first data terminal (D-) 112 is an ideal value excluding cable noise, and the like, 3.3 V which is the voltage value of the first data terminal (D-) 112 may be a voltage center value of the first data terminal (D-) 112 of the first charger. Accordingly, in consideration of cable noise, and the like, the voltage value of the first data terminal (D-) 112 of the first charger may be in a range of 3.0 to 3.6 V.

In the case of a second charger that performs charging if the first data terminal (D-) 112 and the second data terminal (D+) 113 are in a short-circuited state, the maximum output current may be 1A, and the voltage value of the first data terminal (D-) 112 may be in a range of 2.2 to 2.8V.

As shown in FIG. 4, if a second charger having a maximum output current of 700 mA is connected to the external battery device 100 in which the first data terminal (D-) 112 and the second data terminal (D+) 113 of the input terminal 110 are implemented, and the first data terminal (D-) 112 and the second data terminal (D+) 113 are short-circuited, the processor 120 may acquire 5 V*(100 K/(100 K+100 K)) = 2.5 V which is a voltage value of the first data terminal (D-) 112. Since 2.5 V acquired as the voltage value of the first data terminal (D-) 112 is an ideal value excluding cable noise, and the like, 2.5 V which is the voltage value of the first data terminal (D-) 112 may be a voltage center value of the first data terminal (D-) 112 of the second charger. Accordingly, in consideration of cable noise, and the like, the voltage value of the first data terminal (D-) 112 of the second charger may be in a range of 2.2 to 2.8 V.

In the case of a third charger that performs charging if the first data terminal (D-) 112 and the second data terminal (D+) 113 are in a pull-up state, the maximum output current may be 2 A, and a voltage value of the first data terminal (D-) 112 may be in a range of 0.86 to 1.46 V.

As shown in FIG. 4, if a third charger having a maximum output current of 2000 mA is connected to the external battery device 100 in which a first data terminal (D-) 112 and the second data terminal (D+) 113 of the input terminal 110 are implemented, and the first data terminal (D-) 112 and the second data terminal (D+) 113 are pulled up to 1.16 V, the processor 120 may acquire a voltage value of the first data terminal (D-) 112 in a range of 0.86 to 1.46 V by adding the resistance at the charger side.

As described above, the maximum output current of the charger 10 may vary depending on the specifications of the charger 10, and the voltage value of the first data terminal (D-) 112 may vary depending on the specifications of the charger 10.

Accordingly, the processor 120 may set the charging current based on the voltage value of the first data terminal (D-) 112. That is, the processor 120 may recognize a specification (type) of the charger 10 corresponding to the voltage value of the first data terminal (D-) 112 and set the charging current so that the charging current does not exceed the maximum output current of the recognized charger 10. In this case, the processor 120 may set the charging current by comparing the voltage value of the first data terminal (D-) 112 with a preset reference range. Here, the reference range may be preset for each charger 10.

For example, if the voltage value of the first data terminal (D-) 112 is in a first reference range (for example, 3.0 to 3.6 V), the processor 120 may recognize the currently connected charger 10 as the first charger and set the charging current so that the charging current does not exceed the maximum output current of the first charger.

If the voltage value of the first data terminal (D-) 112 is in a second reference range (for example, 2.2 to 2.8 V), the processor 120 may recognize the currently connected charger 10 as the second charger and set the charging current so that the charging current does not exceed the maximum output current of the second charger.

If the voltage value of the first data terminal (D-) 112 is in a third reference range (for example, 0.86 to 1.46 V), the processor 120 may recognize the currently connected charger 10 as the third charger and set the charging current so that the charging current does not exceed the maximum output current of the third charger.

If the charging current is set, the processor 120 may control the charging unit 130 to charge the battery 140 with the set charging current. That is, the processor 120 may control the magnitude of the charging current output from the charging unit 130. The charging unit 130 may convert the current of the external power supplied to the input terminal 110 into the charging current and supply the charging current to the battery 140.

For example, if 0.5 A is set as the charging current, the processor 120 may control the magnitude of the charging current output from the charging unit 130 to 0.5 A. The charging unit 130 may convert the current of the external power supplied to the input terminal 110 to 0.5 A and supply the current to the battery 140.

Meanwhile, since the processor 120 is configured to recognize the charger 10 using only the voltage value of the first data terminal (D-) 112 of the input terminal 110, there is a possibility of misrecognizing the charger 10. If the charger 10 is misrecognized, the processor 120 may set the charging current to be higher or lower than the maximum output current of the charger 10. If the battery 140 is charged with the charging current set to be higher than the maximum output current of the charger 10, an overload may occur, which may cause damage to the charger 10 and the external battery device 100.

In order to prevent the overload from occurring, the processor 120 may measure a voltage drop of the first data terminal (D-) 112 for a preset time during charging, and maintain or change the set charging current based on the voltage drop of the first data terminal (D-) 112.

If the external battery device 100 charges the battery 140 with a charging current higher than the maximum output current of the charger 10, the output voltage of the charger 10 may decrease.

For example, if a 1 A charger having a maximum output current of 1 A is connected and then 2 A is set as a charging current, an output voltage of the 1A charger may decrease from 5 V to 4 V. Further, if a 0.7A charger having a maximum output current of 0.7 A is connected and then 2 A is set as a charging current, an output voltage of the 0.7A charger may decrease from 5 V to 4 V.

Thus, if the external battery device 100 is overcharged, the output voltage of the charger 10 may decrease, and accordingly, a full load (VL) voltage output from the charging unit 130 may decrease.

For example, if the input voltage supplied through the input terminal 110 is 5 V or less, the full load (VL) voltage value of the charging unit 130 may also drop to 5 V or less. Here, as shown in FIG. 5, the VL voltage value according to the input voltage may be preset.

Thus, if the external battery device 100 is overcharged, since the output voltage of the charger 10 decreases, and the output voltage of the charger 10 is input to the external battery device 100, the input voltage of the external battery device 100 may decrease. If the input voltage of the external battery device 100 decreases, the VL voltage value also decreases. If the VL voltage value decreases, the voltage value of the first data terminal (D-) 112 changes, and accordingly, a voltage drop occurs at the first data terminal (D-) 112.

Accordingly, the processor 120 may determine whether to maintain or change the charging current using the voltage drop at the first data terminal (D-) 112.

The processor 120 may measure the voltage drop of the first data terminal (D-) 112, compare the voltage drop of the first data terminal (D-) 112 with a preset threshold, and maintain or change the set charging current depending on the comparison result. In this case, the processor 120 may measure the voltage value of the first data terminal (D-) 112 if a preset time has elapsed after the charging of the battery 140 starts, and measure the voltage drop of the first data terminal (D-) 112 by comparing the measured voltage value of the first data terminal (D-) 112 with an initial voltage value of the first data terminal (D-) 112. Here, the threshold may be a preset value. The threshold may be a value set differently depending on the set charging current.

If the voltage drop of the first data terminal (D-) 112 is lower than or equal to the threshold, the processor 120 may maintain the set charging current and charge the battery 140.

If the voltage drop of the first data terminal (D-) 112 exceeds the threshold, the processor 120 may reset the charging current. In this case, the processor 120 may reset the charging current to a charging current lower than the set charging current.

If it is determined that the charger 10 and the external device 20 are simultaneously connected, the processor 120 may control the charging current generated by the charging unit 130 to be directly transmitted to the external device 20.

The processor 120 may protect the battery 140 by controlling an overcharging voltage, an overdischarge voltage, and a discharge overcurrent of the battery 140.

The processor 120 may block the output current of the battery 140 if the output voltage of the battery 140 reaches a preset overdischarge prevention voltage. Further, the processor 120 may control the output voltage to be supplied from the battery 140 to the DC-DC converter 150 if the output voltage of the battery 140 rises above the overdischarge prevention voltage.

Here, the processor 120 may control the overall configuration in the external battery device 100. The processor 120 may be implemented as a central processing unit (CPU) or a system on chip (SoC), control a plurality of hardware or software components connected to the processor 120 by driving an operating system or application, and perform various types of data processing and calculations. The processor 120 may be configured to execute at least one command stored in a memory (not shown) and store the execution result data in the memory.

As the external battery device 100 configured as described above sets the charging current based on the voltage value of the data terminal (D-) 112 of the input terminal 110, and charges the battery 140 with the set charging current, the battery 140 may be stably charged from any power source, and fire, damage, and the like in the charger 10 or external battery device 100 may be prevented.

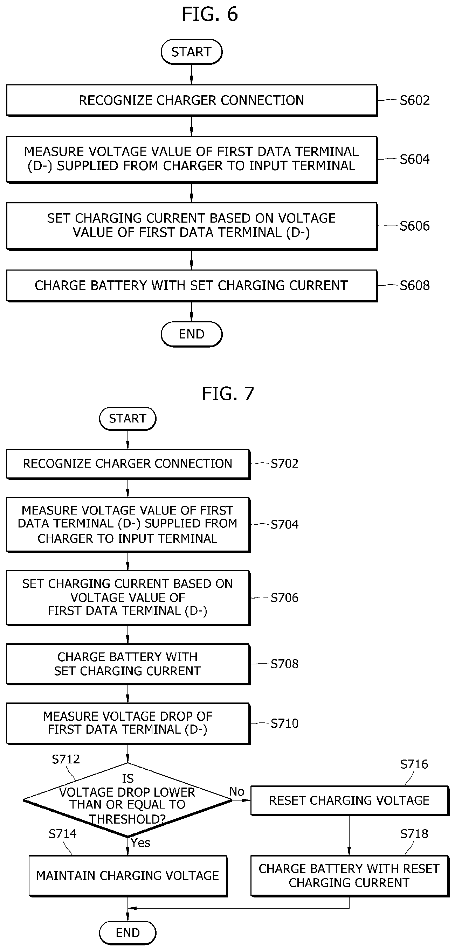

FIG. 6 illustrates a flow chart for describing a charging control method of the external battery device according to one or more embodiments of the present disclosure.

Referring to FIG. 6, if the charger 10 is connected through the USB cable 30 (S602), the processor 120 measures the voltage value of the first data terminal (D-) 112 of the input terminal 110 to which the USB cable 30 is connected (S604).

If operation S604 is performed, the processor 120 sets the charging current based on the voltage value of the first data terminal (D-) 112 (S606). That is, the processor 120 may recognize a specification (type) of the charger 10 corresponding to the voltage value of the first data terminal (D-) 112 and set the charging current so that the charging current does not exceed the maximum output current of the recognized charger 10. In this case, the processor 120 may recognize a specification (current) of the charger 10 and set the charging current by comparing the voltage value of the first data terminal (D-) 112 with a preset reference range.

For example, if the voltage value of the first data terminal (D-) 112 is in a first reference range (for example, 3.0 to 3.6 V), the processor 120 may recognize the currently connected charger 10 as the first charger and set the charging current so that the charging current does not exceed the maximum output current of the first charger. If the voltage value of the first data terminal (D-) 112 is in a second reference range (for example, 2.2 to 2.8 V), the processor 120 may recognize the currently connected charger 10 as the second charger and set the charging current so that the charging current does not exceed the maximum output current of the second charger. If the voltage value of the first data terminal (D-) 112 is in a third reference range (for example, 0.86 to 1.46 V), the processor 120 may recognize the currently connected charger 10 as the third charger and set the charging current so that the charging current does not exceed the maximum output current of the third charger.

If operation S606 is performed, the processor 120 controls the charging unit 130 to charge the battery 140 with the set charging current (S608). That is, the processor 120 may control the magnitude of the charging current output from the charging unit 130. The charging unit 130 may convert the current of the external power supplied to the input terminal 110 into the charging current and supply the charging current to the battery 140.

FIG. 7 illustrates a flow chart for describing a charging control method of an external battery device according to one or more embodiments of the present disclosure.

Referring to FIG. 7, if a charger 10 is connected through a USB cable 30 and recognized (S702), a processor 120 measures a voltage value of a first data terminal (D-) 112 of an input terminal 110 to which the USB cable 30 is connected (S704).

If operation S704 is performed, the processor 120 sets a charging current based on the voltage value of the first data terminal (D-) 112 (S706). That is, the processor 120 may recognize a specification (type) of the charger 10 corresponding to the voltage value of the first data terminal (D-) 112 and set the charging current so that the charging current does not exceed the maximum output current of the recognized charger 10. In this case, the processor 120 may recognize a specification (current) of the charger 10 and set the charging current by comparing the voltage value of the first data terminal (D-) 112 with a preset reference range.

In operation S706, the processor 120 controls a charging unit 130 to charge a battery 140 with the set charging current (S708). That is, the processor 120 may control the magnitude of the charging current output from the charging unit 130. The charging unit 130 may convert the current of external power supplied to the input terminal 110 into the charging current and supply the charging current to the battery 140.

In operation S708, the processor 120 measures a voltage drop of the first data terminal (D-) 112 for a preset certain time (S710).

If the battery 140 of an external battery device 100 is charged with a charging current set to be higher than the maximum output current of the charger 10, an overload may occur, which may cause damage to the charger 10 and the external battery device 100.

Accordingly, the processor 120 may measure the voltage value of the first data terminal (D-) 112 after a preset time has elapsed after the charging of the battery 140 starts, and measure the voltage drop of the first data terminal (D-) 112 by comparing the measured voltage value of the first data terminal (D-) 112 with an initial voltage value of the first data terminal (D-) 112.

In operation S710, the processor 120 determines whether the voltage drop of the first data terminal (D-) 112 is lower than or equal to a threshold by comparing the voltage drop of the first data terminal (D-) 112 with the preset threshold (S712).

As a determination result of operation S712, if the voltage drop of the first data terminal (D-) 112 is lower than or equal to the threshold, the processor 120 maintains the set charging current and charges the battery 140 (S714).

As the determination result of operation S712, if the voltage drop of the first data terminal (D-) 112 is not lower than or equal to the threshold, the processor 120 resets the charging current (S716), and controls the charging unit 130 to charge the battery 140 with the reset charging current (S718). In this case, processor 120 may reset the charging current to a charging current lower than the set charging current.

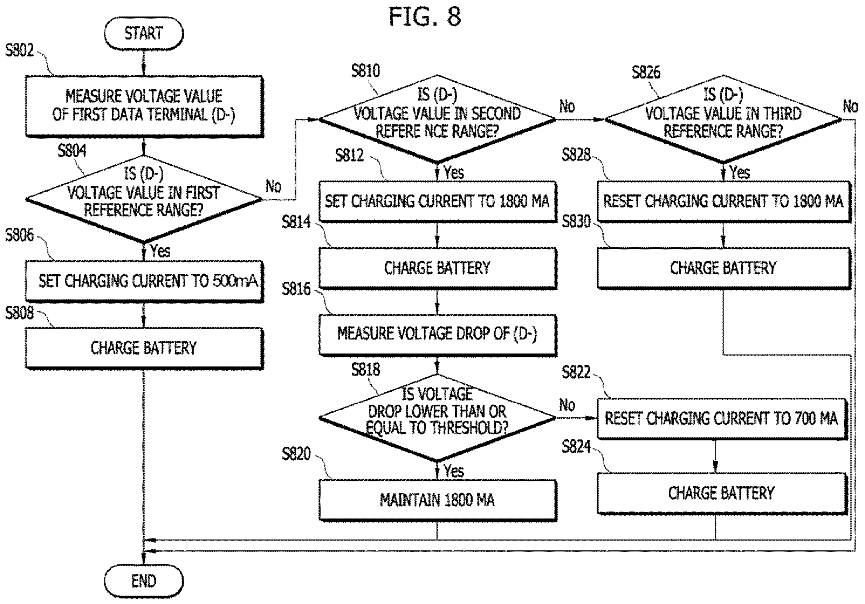

FIG. 8 illustrates a flow chart for describing a charging control method of an external battery device according to still another embodiment of the present disclosure.

Referring to FIG. 8, a processor 120 measures a voltage value of a first data terminal (D-) 112 of an input terminal 110 to which a USB cable 30 is connected (S802).

In operation S802, the processor 120 determines whether the voltage value of the first data terminal (D-) 112 is in a first reference range (for example, 3.0 to 3.6 V) (S804).

As a determination result of operation S804, if the voltage value of the first data terminal (D-) 112 is in the first reference range (for example, 3.0 to 3.6 V), the processor 120 recognizes a currently connected charger 10 as a first charger having a maximum output current of 500 mA and sets the charging current to 500 mA (S806).

In operation S806, the processor 120 controls the magnitude of the charging current output from a charging unit 130 to 500 mA to charge a battery 140 (S808). That is, the processor 120 may control the charging current output from the charging unit 130 to 500 mA, and the charging unit 130 may convert the current of external power supplied to the input terminal 110 into the charging current and supply the charging current to the battery 140.

As the determination result of operation S804, if the voltage value of the first data terminal (D-) 112 is not in the first reference range (for example, 3.0 to 3.6 V), the processor 120 determines whether the voltage value of the first data terminal (D-) 112 is in a second reference range (for example, 2.2 to 2.8 V) (S810).

As a determination result of operation S810, if the voltage value of the first data terminal (D-) 112 is in the second reference range (for example, 2.2 to 2.8 V), the processor 120 recognizes the currently connected charger 10 as a second charger having a maximum output current of 1800 mA and sets the charging current to 1800 mA (S812).

In operation S812, the processor 120 controls the magnitude of the charging current output from the charging unit 130 to 1800 mA to charge the battery 140 (S814). That is, the processor 120 may control the magnitude of the charging current output from the charging unit 130 to 1800 mA, and the charging unit 130 may convert the current of external power supplied to the input terminal 110 into 1800 mA and supply the current to the battery 140.

Meanwhile, the charger 10 whose voltage value of the first data terminal (D-) 112 is in the second reference range (for example, 2.2 to 2.8 V) may be various chargers, such as a charger having a maximum output current of 700 mA, a charger having a maximum output current of 1000 mA, a charger having a maximum output current of 2000 mA, and the like.

If the processor 120 is connected to a charger having a maximum output current of 2000 mA, the processor 120 may set the charging current to 1800 mA and charge the battery 140. However, if the processor 120 is connected to a charger having a maximum output current of 700 mA or a charger having a maximum output current of 1000 mA, an overload may occur, which may damage the charger 10 and the external battery device 100 if the charging current is set to 1800 mA and the battery 140 is charged.

Accordingly, the processor 120 measures a voltage drop of the first data terminal (D-) 112 after a preset time has elapsed after the charging of the battery 140 starts (S816). That is, the processor 120 may measure the voltage value of the first data terminal (D-) 112 after the preset time has elapsed after the charging of the battery 140 starts, and measure the voltage drop of the first data terminal (D-) 112 by comparing the measured voltage value of the first data terminal (D-) 112 with an initial voltage value of the first data terminal (D-) 112.

In operation S816, the processor 120 determines whether the voltage drop of the first data terminal (D-) 112 is lower than or equal to a threshold by comparing the voltage drop of the first data terminal (D-) 112 with the preset threshold (S818). Here, the threshold may be a preset value, for example, 37 mV.

As a determination result of operation S818, if the voltage drop of the first data terminal (D-) 112 is lower than or equal to the threshold, the processor 120 controls the charging unit 130 to charge the battery 140 by maintaining the charging current of 1800 mA (S820).

As the determination result of operation S818, if the voltage drop of the first data terminal (D-) 112 is not lower than or equal to the threshold, the processor 120 resets the charging current to 700 mA (S822), and controls the charging unit 130 to charge the battery 140 by controlling the magnitude of the charging current output from the charging unit 130 to 700 mA (S824).

As the determination result of operation S810, if the voltage value of the first data terminal (D-) 112 is not in the second reference range (for example, 2.2 to 2.8 V), the processor 120 determines whether the voltage value of the first data terminal (D-) 112 is in a third reference range (for example, 0.86 to 1.46 V) (S826).

As a determination result of operation S826, if the voltage value of the first data terminal (D-) 112 is in the third reference range (for example, 0.86 to 1.46 V), the processor 120 recognizes the currently connected charger 10 as a third charger having a maximum output current of 1800 mA and sets the charging current to 1800 mA (S828).

In operation S828, the processor 120 controls the magnitude of the charging current output from the charging unit 130 to 1800 mA to charge the battery 140 (S830). That is, the processor 120 may control the magnitude of the charging current output from the charging unit 130 to 1800 mA, and the charging unit 130 may convert the current of external power supplied to the input terminal 110 into 1800 mA and supply the current to the battery 140.

According to the present disclosure, as described above, as the charging current is set based on the voltage value of the first data terminal D- of the input terminal connected to the charger through the universal serial bus (USB) cable, and the battery of the external battery device is charged with the set charging current, the external battery can be charged according to the current specifications of the charger, and accordingly, not only the charger but also the external battery device can be protected.

Further, according to the present disclosure, as the charging current is adjusted depending on the specifications of the charger and the battery of the external battery device is charged with the adjusted charging current, the battery can be stably charged with any charger, and damage, fire, and the like in the charger and the external battery device can be prevented.

According to the present disclosure, as a charging current is set based on a voltage value of a first data terminal D- of an input terminal connected to a charger through a universal serial bus (USB) cable, and a battery is charged with the set charging current, an external battery can be charged according to the current specifications of the charger, and accordingly, not only the charger but also the external battery device can be protected.

According to the present disclosure, as the charging current is adjusted depending on the specifications of the charger and the external battery is charged with the adjusted charging current, the battery can be stably charged with any charger, and damage, fire, and the like in the charger and the external battery device can be prevented.

However, effects which may be acquired through the present disclosure are not limited to the above-described effects, and other technical effects which are not mentioned will be clearly understood by those of ordinary skill in the art from the description of the disclosure disclosed below.

The embodiments described herein may be implemented, for example, as a method or process, a device, a software program, a data stream, or a signal. Although discussed in the context of a single type of implementation (for example, discussed only as a method), features discussed herein may also be implemented in other forms (for example, a device or a program). The device may be implemented by suitable hardware, software, firmware, and the like. The method may be implemented on a device, such as a processor that generally refers to a processing device including a computer, a microprocessor, an integrated circuit, a programmable logic device, etc. The processor includes a communication device such as a computer, a cell phone, a personal digital assistant (PDA), and other devices that facilitate communication of information between the device and end-users.

Although the present disclosure has been described with reference to embodiments and drawings illustrating aspects thereof, the present disclosure is not limited thereto. Various modifications and variations can be made by a person of ordinary skill in the art to which the present disclosure belongs within the scope of the present disclosure and the claims and their equivalents, below.

Example embodiments have been disclosed herein, and although specific terms are employed, they are used and are to be interpreted in a generic and descriptive sense only and not for purpose of limitation. In some instances, as would be apparent to one of ordinary skill in the art as of the filing of the present application, features, characteristics, and/or elements described in connection with a particular embodiment may be used singly or in combination with features, characteristics, and/or elements described in connection with other embodiments unless otherwise specifically indicated. Accordingly, it will be understood by those of skill in the art that various changes in form and details may be made without departing from the scope of the present invention as set forth in the following claims.

## Claims

1. An external battery device (100), comprising:
a battery (140);
an input terminal (110) that receives external power from a charger (10) connectable through a universal serial bus, USB, cable (30);
a charging unit (130) that charges the battery (140); and
a processor (120) configured to measure a voltage value of a first data terminal (112) of the input terminal (110), set a charging current based on the voltage value of the first data terminal (112), and control the charging unit (130) to charge the battery (140) with the charging current that is set.

2. The external battery device (100) as claimed in claim 1, wherein the processor (120) is further configured to compare the voltage value of the first data terminal (112) with a preset reference range to set the charging current, and
wherein the processor (120) is further configured to set a first charging current for a first reference range as the charging current if the voltage value of the first data terminal (112) is in the first reference range, set a second charging current set for a second reference range as the charging current if the voltage value of the first data terminal (112) is in the second reference range, and set a third charging current set for a third reference range as the charging current if the voltage value of the first data terminal (112) is in the third reference range.

3. The external battery device (100) as claimed in claim 1 or 2, wherein the processor (120) is further configured to measure a voltage drop of the first data terminal (112) for a preset time during charging with the charging current that is set, and maintain or change the charging current that is set based on the voltage drop of the first data terminal (112).

4. The external battery device (100) as claimed in claim 3, wherein the processor (120) is further configured to measure the voltage value of the first data terminal (112) if a preset time has elapsed after charging of the battery (140) starts, and compare the voltage value of the first data terminal (112) measured with an initial voltage value of the first data terminal (112) to measure the voltage drop of the first data terminal (112).

5. The external battery device (100) as claimed in claim 3 or 4, wherein the processor (120) is further configured to reset the charging current to a charging current lower than the charging current that is set and control the charging unit (130) to charge the battery (140) with the charging current that is reset if the voltage drop of the first data terminal (112) exceeds a preset threshold.

6. The external battery device (100) as claimed in any of the preceding claims, wherein the input terminal (110) includes a power terminal (111) connectable to a power pin (11) of a charger (10), a first data terminal (112) (D-) connectable to a first data pin (12) (D-) of a charger (10), and a second data terminal (113) (D+) connectable to a second data pin (13) (D+) of a charger (10).

7. A charging control method of an external battery device (100) of any of the preceding claims, the charging control method comprising:
measuring, by a processor (120), a voltage value of a first data terminal (112) of an input terminal (110) to which a USB cable (30) is connected if a charger (10) is connected through the USB cable (30);
setting, by the processor (120), a charging current based on the voltage value of the first data terminal (112); and
controlling, by the processor (120), a charging unit (130) to charge a battery (140) with the charging current that is set.

8. The charging control method as claimed in claim 7, wherein, in the setting of the charging current, the processor (120) compares the voltage value of the first data terminal (112) with a preset reference range to set the charging current.

9. The charging control method as claimed in claim 7 or 8, after the controlling, further comprising measuring, by the processor (120), a voltage drop of the first data terminal (112) for a preset time after charging of the battery (140) starts, and maintaining or changing the charging current that is set based on the voltage drop of the first data terminal (112).

10. The charging control method as claimed in claim 9, wherein, in the maintaining or changing of the charging current that is set, the voltage value of the first data terminal (112) is measured by the processor (120) if a preset time has elapsed after charging of the battery (140) starts, and compares the voltage value of the first data terminal (112) measured with an initial voltage value of the first data terminal (112) to measure the voltage drop of the first data terminal (112).

11. The charging control method as claimed in claim 8 or 9, wherein, in the maintaining or changing of the charging current that is set, the charging current that is set is maintained by the processor (120) if the voltage drop of the first data terminal (112) is lower than or equal to a preset threshold, and resets the charging current to a charging current lower than the charging current that is set and controls the charging unit (130) to charge the battery (140) with the charging current that is reset if the voltage drop of the first data terminal (112) exceeds the preset threshold.
